# EUROPEAN PATENT SPECIFICATION

(11) **EP 3 380 265 B1**
(45) Date of publication and mention of the grant of the patent: **02.03.2022**
(21) Application number: 16801099.9
(22) Date of filing: 10.11.2016
(51) Int. Cl.: B23K 9/04, B22F 3/10, B23K 26/06, B23K 26/073, B29C 67/00, B33Y 10/00, B33Y 30/00, B23K 26/342

(54) **SYSTEM AND METHOD FOR SINGLE CRYSTAL GROWTH WITH ADDITIVE MANUFACTURING**
SYSTEM UND VERFAHREN ZUR EINKRISTALLZÜCHTUNG MIT GENERATIVER FERTIGUNG
SYSTÈME ET PROCÉDÉ POUR CROISSANCE DE MONOCRISTAL AVEC FABRICATION ADDITIVE

(30) Priority: 23.11.2015 US 201514949298
(43) Date of publication of application: 03.10.2018
(73) Proprietor: Hobart Brothers Company, Troy, Ohio 45373 (US)
(72) Inventor: XIAO, Zhigang, Glenview, Illinois 60025 (US)
(74) Representative: Trinks, Ole
(86) International application number: PCT/US2016/061381
(87) International publication number: WO 2017/091363

(56) References cited:
- US-A1- 2006 054 079
- US-A1- 2013 309 420
- US-A1- 2015 021 379

## Description

### BACKGROUND

The present disclosure relates generally to additive manufacturing, and more particularly, to a system and a method for single crystal growth in additive manufacturing according to the preamble of claims 1 and 9 (see for example US 2006/054079).

Various manufactured products may incorporate components with different materials. As may be appreciated, the different materials of the manufactured products may be joined together by fasteners, mating geometries, welding, or other processes. Fasteners or complementary geometries may add components or weight to the joint. Three-dimensional additive manufacturing with metals can be useful for creating durable components in a controlled and precise manner. Unfortunately, such processes can be complicated and expensive.

### BRIEF DESCRIPTION

A first embodiment is disclosed in the additive manufacturing system of claim 1.

A second embodiment is disclosed in the method of claim 9.

### DRAWINGS

These and other features, aspects, and advantages of the present disclosure will become better understood when the following detailed description is read with reference to the accompanying drawings in which like characters represent like parts throughout the drawings, wherein:
FIG. 1 is a diagram of an embodiment of an additive manufacturing system having a heating system and a part, in accordance with aspects of the present disclosure;
FIG. 2 is a diagram of an embodiment of the additive manufacturing system having a heating system and a part, in accordance with aspects of the present disclosure; and
FIG. 3 is a diagram of an embodiment of the additive manufacturing system having a heating system and a part, in accordance with aspects of the present disclosure.

### DETAILED DESCRIPTION

One or more specific embodiments of the present disclosure will be described below. In an effort to provide a concise description of these embodiments, all features of an actual implementation may not be described in the specification. It should be appreciated that in the development of any such actual implementation, as in any engineering or design project, numerous implementation-specific decisions must be made to achieve the developers' specific goals, such as compliance with system-related and business-related constraints, which may vary from one implementation to another. Moreover, it should be appreciated that such a development effort might be complex and time consuming, but would nevertheless be a routine undertaking of design, fabrication, and manufacture for those of ordinary skill having the benefit of this disclosure.

Embodiments of the present disclosure are directed toward an additive manufacturing system having a heating system to enable improvements in single crystal growth with the additive manufacturing system to manufacture a part of high strength and quality. For example, the heating system may include a primary heating system for generating a single crystal growth zone in a part that is formed with the additive manufacturing system and a secondary heating system for generating a transition zone about or around the single crystal growth zone. As discussed in detail below, the transition zone may enable more consistent and reliable generation and growth of single crystal formations within the part as material is added to the part. Operation of the heating system and other components of the additive manufacturing system may be regulated and coordinated, such that the single crystal growth zone and the transition zone are generated and maintained in a desired location (e.g., based on a changing location of the additive manufacturing process). In this manner, a temperature gradient between the location of the additive manufacturing process (e.g., the location of single crystal growth) and a region of the part away from the additive manufacturing process may be precisely controlled, thereby improving formation of single crystal molecular structures as a material is added to the part (e.g., as the part is built) and reducing formation of multi-crystal molecular structures in the part. As will be appreciated, improving the formation and creation of single crystal molecular structures within the part may improve the strength and durability of the part.

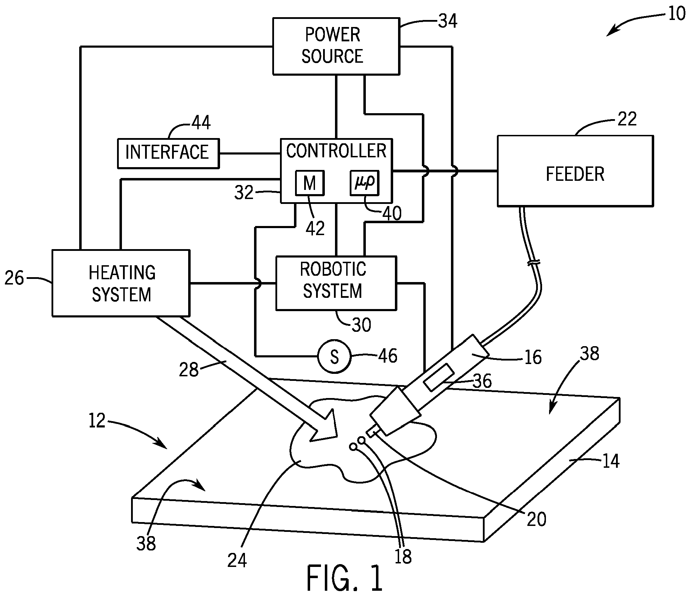

Turning to FIG. 1, an embodiment of an additive manufacturing system 10 that additively forms (e.g., prints, builds) a part 12 is shown. The additively formed part 12 may begin as a substrate 14, such as a single crystal substrate. The substrate 14 may be formed using an electron beam zone melting method (e.g., for refractory materials), a Bridgman method (e.g., for lower melting point materials), or any other suitable method. In certain embodiments, the material used to form the substrate 14 may be a pure metal (e.g., a single element composition metal). For example, the material used to form the substrate 14 may be a tungsten, niobium, molybdenum, tantalum, or other refractory metal. In other embodiments, the substrate 14 may be an alloy, such as a nickel-based alloy, titanium-based alloy or a cobalt-based alloy. Before the additive manufacturing process is initiated, the substrate 14 may be cut and/or designed into a desired shape (e.g., a sheet, circular shape, etc.). For example, the substrate 14 may be cut, designed, or formed using an electron discharge machining process or laser cutting process.

The additive manufacturing system 10 includes an additive manufacturing tool 16 that deposits material or droplets 18 of material 20 to form (e.g., print, build) the part 12. That is, the additive manufacturing tool 16 deposits the droplets 18 onto the substrate 14. The additive manufacturing tool 16 may utilize one or more types of energy to form and deposit the droplets 18 to form the part 12. The one or more types of energy utilized by the additive manufacturing tool 16 may include, but are not limited to, an electric power output, photonic energy (e.g., laser), or any combination thereof.

The additive manufacturing tool 16 heats the material 20 (e.g., an electrode), which is supplied from a feeder 22, to form the droplets 18. The material 20 supplied by the feeder 22 may be one of a variety of metallic materials that include, but are not limited to, aluminum alloys, steel alloys, iron, copper, manganese, silicon, chromium, titanium, molybdenum, and nickel. In certain embodiments, the material 20 may include powders, solid wires, cored wires, tubular wires, coated wires, or any combination thereof. As discussed herein, the droplets 18 are units of material 20 transfer. Each droplet 18 may become a "micro-deposit" when solidified, and the part 12 is formed from multiple micro-deposits. In other words, the droplets 18 of the material 20 (e.g., electrode) are deposited onto a work region 24 (e.g., a work region of the substrate 14) to form the part 12.

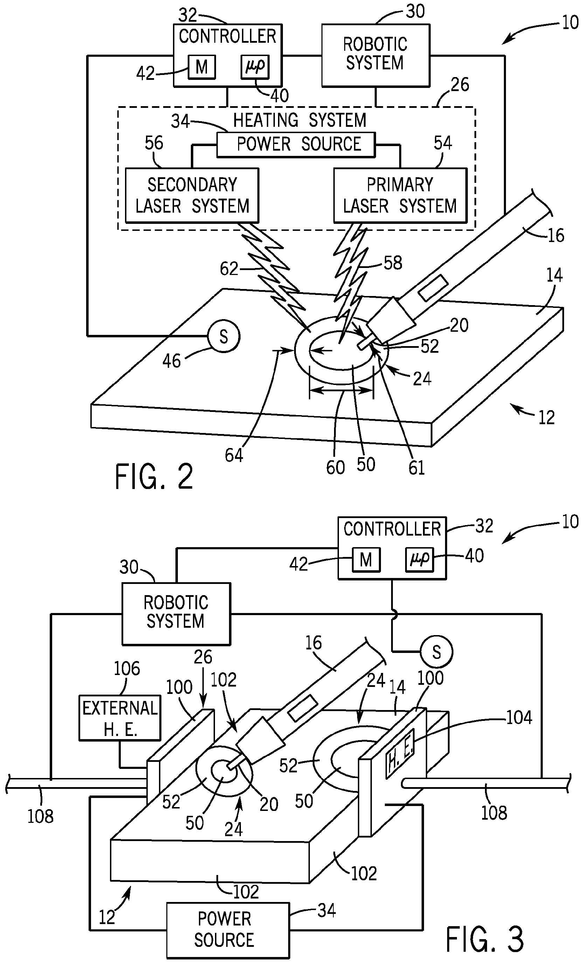

As mentioned above, the additive manufacturing system 10 includes a heating system 26 configured to apply heat 28 to the part 12 and/or the substrate 14. In particular, the heating system 26 applies heat 28 to the work region 24 of the part 12 in a manner that improves single crystal growth and formation within the part 12 and the droplets 18 (e.g., the material 20) during the additive manufacturing process. As discussed in detail below, the heating system 26 is configured to generate a single crystal growth zone in the work region 24 where the droplets 18 are deposited onto the part 12. Additionally, the heating system 26 is configured to generate a transition zone disposed about the single crystal growth zone. As discussed below, the transition zone is a "buffer" or temperature gradient zone that blocks the droplets 18, the substrate 14, and the part 12 in the work region 24 from cooling and/or solidifying too quickly. In this manner, single crystal formation and/or growth in the work region 24 of the part 12 may be facilitated and/or improved. For example, the heating system 26 may reduce the growth of multigrain or multi-crystal formations during the additive manufacturing process. As will be appreciated, improved single crystal molecular formations may improve the strength and quality of the part 12 formed by the additive manufacturing process. Details of the heating system 26 are discussed in further detail below with reference to FIGS. 2 and 3.

The additive manufacturing system 10 also includes a robotic system 30 configured to control movement of one or more components of the additive manufacturing system 10. For example, the robotic system 30 may be configured to control movement of one or more components of the heating system 26 or the additive manufacturing tool 16. The robotic system 30 may include robotic arms, robotic grips, servomotors, gears, frames, tracks, and so forth, which may enable movement and/or automation of various components of the additive manufacturing system 10.

The robotic system 30 and other components of the additive manufacturing system 10 may be controlled by a controller 32. For example, the controller 32 may control the application of the droplets 18 to form the part 12. In certain embodiments, the controller 32 may be a single control system with a single controller, or the controller 32 may include multiple control systems or controllers. For example, multiple control systems of the controller 32 may be configured to regulate different component or systems of the additive manufacturing system 10 and/or the multiple control systems may be responsive to a single, central controller of the controller 32. In some embodiments, the controller 32 is coupled to multiple additive manufacturing tools 16, each supplying a separate anchor material 20 via a respective electrode.

The controller 32 may also control a power source 34 (e.g., a current-regulated power source) to adjust the power output (e.g., current output, voltage output, photonic energy) provided to the additive manufacturing tool 16 to melt the one or more materials 20 into the droplets 18. As may be appreciated, the power source 34 may include, but is not limited to, an engine-driven generator, a welding power supply, an inverter, laser, or any combination thereof. The controller 32 may control the power source 34 to provide a DC or AC power output to the material 20 (e.g., electrode) in a controlled waveform, similar to a pulsed welding process or a short circuit welding process (e.g., regulated metal deposition (RMD^{™})). In some embodiments, the controller 32 controls the power source 34 and/or the feeder 22 to provide power output to the material 20 via the additive manufacturing tool 16 to enable a modified short circuit welding process (e.g., controlled short circuit) to form the part 12. Additionally, the controller 32 can facilitate formation of the part 12 by controlling the additive manufacturing tool 16 to extend and retract the material 20 (e.g., electrode) during a controlled short circuit welding process. The power output provided to the additive manufacturing tool 16 melts the material 20 (e.g., electrode) into the droplets 18, which are deposited via an arc to the part 12 as micro-deposits. That is, in some embodiments, the material 20 is a welding wire, the additive manufacturing tool 16 is a welding torch configured for a pulsed welding process or a short circuit welding process, and the feeder 22 is a welding wire feeder. The welding torch may layer micro-deposits via an arc, thereby forming (e.g., building up, printing) the part 12 from welding wire via a pulsed welding process and/or a short circuit welding process (e.g., RMD). As may be appreciated, some embodiments of the additive manufacturing system 10 may include a gas supply (not shown) configured to provide one or more shielding gases to the additive manufacturing tool 16. The one or more shielding gases may include, but are not limited to, argon, carbon dioxide, helium, nitrogen, hydrogen, and combinations thereof. The system 10 may be configured to include a flux delivery system configured to provide one or more fluxes. These fluxes are of different compositions to provide different end results, in particular, metallurgical results.

As discussed above, the controller 32 may control power output for processes utilizing electrical arc and/or photonic energy to heat the material 20. The controller 32 may control the rate at which the droplets 18 are applied to the part 12 by controlling the power source 34. In some embodiments, the controller 32 controls a heating device 36 (e.g., inductor coil, resistive heater) of the additive manufacturing tool 16 to preheat the material 20 (e.g., electrode). In this manner, the controller 32 may control the heat applied to the material 20 to form the droplets 18.

As mentioned above, the controller 32 may control the robotic system 30. More particularly, the controller 32 may regulate operation of the robotic system 30 to coordinate movement of the components of the heating system 26 and the additive manufacturing tool 16. For example, the controller 32 may regulate operation of the robotic system 30 (and thus movement of the heating system 26 and the additive manufacturing tool 16) such that the single crystal growth zone and the transition zone of the work region 24 are moved in conjunction with the additive manufacturing tool 16. In particular, the controller 32 may regulate operation of the robotic system 30 such that the single crystal growth zone and the location where droplets 18 are added to the work region 24 are colocated (e.g., the droplets 18 are added to the substrate 14 within the single crystal growth zone). In this manner, a temperature gradient between the work region and a region of the part 12 that is not contemporaneously subject to the additive manufacturing process (e.g., regions 38) may be precisely controlled to promote single crystal growth within the part 12 during the additive manufacturing process. In other words, the controller 32 may regulate operation of the heating system 26 and the additive manufacturing tool 16 to promote single crystal growth within the droplets 18 and the work region 24 as the material 20 is added to the part 12.

In certain embodiments, the controller 32 may operate according to a set of instructions (e.g., code) executed by a processor 40. The processor 40 may load the set of instructions from a memory 42 based at least in part on the part 12 and the materials 20. In some embodiments, an operator (e.g., host computer) may provide the set of instructions directly to the controller 32 via an operator interface 44. For example, the operator may load a set of instructions for forming the part 12 from a three-dimensional model (e.g., computer aided design (CAD) model) of the part 12 produced by a three-dimensional 3-D CAD tool. In some embodiments, the controller 32 may receive and/or produce a set of instructions to produce the part 12 with a desired material 20. For example, the controller 32 may utilize a 3-D CAD model of the part 12 to control the robotic system 30 to produce the part 12 from the material 20. Additionally, or in the alternative, an operator may input information about the part 12 and the material 20 into the operator interface 44, and the controller 32 may determine and/or modify the set of instructions to form the part 12 with desired characteristics. The set of instructions directs the controller 32 to control the formation, and application of each droplet 18 as a micro-deposit to form the part 12 with desired characteristics.

The controller 32 may also use input from one or more sensors 46 (e.g., feedback) to control the operation of the additive manufacturing system 10. For example, the sensors 46 may include position sensors, temperature sensors, light sensors, accelerometers, magnetic sensors, or any other suitable sensor. The controller 32 may adapt the set of instructions based at least in part on the input from the sensors 46 to compensate for changes to the material 20, the substrate 14, or the part 12. In certain embodiments, the controller 32 may adapt the application location and/or the heating of the droplets 18 and/or the heating of the work region 24 during the formation of the part 12 if the input from the sensors 46 indicates a change the temperature of the substrate 14, the part 12, and/or a portion of the work region 24 (e.g., the single crystal growth zone and/or the transition zone). Additionally, or in the alternative, the controller 32 may adapt the application and/or the heating of the droplets 18 and/or the work region 24 if the input from the sensors 46 indicates a deflection or burn through of the part 12 and/or the substrate 14.

The controller 42 may also adjust a location of the additive manufacturing tool 16 and/or one or more components of the heating system 26 relative to the part 12 and/or the substrate 14 via feedback from the sensors 46. In certain embodiments, the controller 32 may determine the application location of the material 20 prior to formation of the droplets 18 according to the set of instructions and/or according to a detected operating parameter (e.g., temperature) of the work region 24. For example, the controller 32 may control the application location of the material 20 based on a detected temperature of the work region 24, such that droplets 18 are applied when the work region 24 is at a temperature that promotes or facilitates single crystal growth within the part 12, the substrate 14, and/or the droplets 18 applied.

FIG. 2 is a diagram of the additive manufacturing system, illustrating an embodiment of the heating system 26. As discussed above, the heating system 26 is configured to heat the work region 24 of the substrate 14 where droplets 18 (e.g., material 20) are added to the substrate 14 via the additive manufacturing tool 16 to form the part 12. Specifically, the heating system 26 is configured to heat a single crystal growth zone 50 of the work region 24 and a transition zone 52 disposed about the single crystal growth zone 50. To this end, the heating system 26 includes a primary laser system 54 and a secondary laser system 56.

The primary laser system 54 is configured to heat the single crystal growth zone 50 (e.g., with a primary laser beam 58). The primary laser system 54 heats the single crystal growth zone 50 to a molten temperature (e.g., melting temperature of the substrate 14) that facilitates and promotes single crystal molecular growth in the substrate 14, the droplets 18 applied to the substrate, and the part 12. As such, the primary laser system 54 is configured to heat the single crystal growth zone 50 to a temperature at or greater than the melting temperature of the substrate 14. In the illustrated embodiment, the single crystal growth zone 50 has a diameter 60. In certain embodiments, the diameter 60 of the single crystal growth zone 50 may be approximately two to three times the size of a diameter 61 of the material 20 (e.g., electrode) applied to the substrate 14.

The secondary laser system 56 emits a secondary laser beam 62 toward the substrate 14 to heat the transition zone 52, which is disposed about the single crystal growth zone 50. In other words, the transition zone 52 a generally annular or ring-shaped zone disposed about the single crystal growth zone 50. In certain embodiments, the secondary laser system 56 is configured to heat the transition zone 52 to a temperature of approximately (e.g., within 5, 10, 20, 30, or 40 percent) 5 to 20 degrees Centigrade less than the single growth crystal zone 50. In the illustrated embodiment, the transition zone 52 has a thickness 64. In the present invention, the thickness 64 is approximately (e.g., within 5, 10, 20, 30, or 40 percent) 1/3 or ½ the diameter 60 of the single crystal growth zone 50.

Additionally, in certain embodiments, the heating system 26 may include a gas system (not shown) to create a gaseous working zone about the primary laser beam 58 and/or the secondary laser beam 62. For example, the gas system may create a gaseous working zone of helium, argon, or other inert gas around the primary laser beam 58 and/or the secondary laser beam 62. In other embodiments, the heating system 26 may include a vacuum system (not shown) configured to create a vacuum around the primary laser beam 58 and/or the secondary laser beam 62.

In some embodiments, one or more of the sensors 46 may be used to verify that the heating system 26 adequately heats the single crystal growth zone 50 to a melting temperature of the substrate 14 and that the heating system 26 heats the transition zone 52 to a temperature of approximately (e.g., within 5, 10, 20, 30, or 40 percent) 10 to 20 degrees Centigrade less than the single growth crystal zone 50. That is, the controller 42 may regulate the operation of the heating system 26 based on the feedback from the sensors 46 to achieve as desired temperature gradient across the single crystal growth zone 50 and transition zone 52.

As mentioned above, the heating system 26 is configured to control a temperature gradient between the single crystal growth zone 50 and the transition zone 52 to promote single crystal molecular growth within the part 12 as the material 20 is added to the substrate 14 during the additive manufacturing process. More particularly, the heating system 26 ensures that the material 20 (e.g., the droplets 18) added to the substrate 14 do not cool too quickly and thus form multi-crystal molecular structures. To this end, the controller 32 may be configured to adjust the position of the primary laser system 54 and the secondary laser system 56 (e.g., via the robotic system 30) as the additive manufacturing tool 16 changes position during the additive manufacturing process. Thus, as the additive manufacturing tool 16 moves across the substrate 14 (e.g., via control by the controller 32) and continually adds the material 20 to the substrate 14 to build the part 12, the controller 32 and the robotic system 30 may also adjust the position of the primary laser system 54 and the secondary laser system 56 (e.g., via the robotic system 30). As a result, the single crystal growth zone 50 and the transition zone 52 (e.g., the work region 26) may move with the additive manufacturing tool 16 and the material 20, as the material 20 is added to the substrate 14. That is, the controller 32 may regulate operation of the robotic system 30 such that the single crystal growth zone 50 and the location where droplets 18 are added to the work region 24 are colocated (e.g., the droplets 18 are added to the substrate 14 within the single crystal growth zone 50, thereby promoting single crystal growth within the substrate 14 and the droplets 18 added to the substrate). In this manner, the material 20 and the droplets 18 may be continually added within the single crystal growth zone 50 (and surrounded by the transition zone 52), and single crystal molecular growth of the droplets 18, the part 12, and the substrate 14 may be facilitated more reliably and consistently.

FIG. 3 is a diagram of the additive manufacturing system 10, illustrating another embodiment of the heating system 26. In the illustrated embodiment, the heating system 26 includes heated plates 100 positioned adjacent to edges 102 of the substrate 14. In certain embodiments, the heated plates 100 may be ceramic heated plates. The heated plates 100 are positioned against the edges 102 of the substrate 104 to contain the single crystal growth zone 50 and the transition zone 52 as the additive manufacturing process moves towards one or more of the edges 102. In other words, the heating plates 100 are positioned against the edges 102 to help maintain the structural form of the substrate 14 at the edges 102 when the substrate 14 is heated at, near, or above melting temperature by the heating system 26 (e.g., when the additive manufacturing process occurs near the edges 102). In certain embodiments, the heating plates 100 are configured to heat the edges 102 of the substrate 14 to a temperature of approximately (e.g., within 5, 10, 20, 30, or 40 percent) 10 to 20 degrees Centigrade of the single crystal growth zone 50 (e.g., the melting temperature of the substrate 14). As a result, the heating plates 100 may also block rapid cooling of the substrate 14 and droplets 18, thereby blocking multi-crystal molecular formations within the part 12. As will be appreciated, the heating plates 100 shown in FIG. 3 may be used in conjunction with the components of the heating system 26 comprising two laser systems (e.g., primary laser system 54 and secondary laser system 56) shown in FIG. 2.

In certain embodiments, the heating plates 100 may include an integrated heating element 104, such as an inductive coil, a resistive element, or other heating element. In other embodiments, the heating plates 100 may include external heating elements 106, such as a torch or other heating element. In either embodiment, the heating plates (e.g., the integrated heating element 104 and/or the external heating element 106) may be powered by the power source 34.

Additionally, as with the embodiments of the heating system 26 described above, positioning of the heating plates 100 may be regulated by the robotic system 30 and/or the controller 32. For example, the robotic system 30 may include robotic arms 108 configured to adjust the position of one the heated plates 100. In certain embodiments, the controller 32 may regulate operation of the robotic arms 108 such that the heated plates 100 are positioned against the edges 102 of the substrate 14 when the additive manufacturing tool 16 (and thus the single crystal growth zone 50 and the transition zone 52) moves near the edges 102 of the substrate 14. Similarly, the controller 32 may actuate the robotic arms 108 to withdrawn the heated plates 108 when the additive manufacturing tool 16 moves away from the edges 102. To enable this control scheme, one or more of the sensors 46 may be a position sensor configured to detect a position of the additive manufacturing tool 16, a temperature sensor configured to detect a temperature of the work region 26 or one of the edges 102, or any other suitable sensor configured to detect presence of the additive manufacturing process near one of the edges 102.

As discussed above, embodiments of the present disclosure are directed toward the additive manufacturing system 10 having the heating system 26 configured to enable improvements in single crystal molecular growth with the additive manufacturing system 10 to manufacture parts 12 of high strength and quality. For example, the heating system 26 may include the primary laser system 54 for generating the single crystal growth zone 50 in the part 12 that is formed with the additive manufacturing system 10. The heating system 26 may also include the secondary laser system 56 for generating the transition zone 52 about or around the single crystal growth zone 50. As discussed above, the transition zone 52 enables more consistent and reliable generation and growth of single crystal molecular formations within the substrate 14 of the part 12 and the material 20 added to the part 12 because the transition zone 52 gradually slows the cooling of the substrate 14 and the material 20 during and after the material 20 is added to the work region 24. As discussed above, operation of the heating system 26 and other components of the additive manufacturing system 10may be regulated and coordinated, such that the single crystal growth zone 50 and the transition zone 52 are generated and maintained in a desired location (e.g., based on a changing location of the additive manufacturing tool 16). In this manner, the temperature gradient between the location of the additive manufacturing process (e.g., the location of the single crystal growth zone 50) and a region of the part 12 away from the additive manufacturing tool 16 may be precisely controlled, thereby improving formation of the single crystal molecules as the part 12 is built.

## Claims

1. An additive manufacturing system (10), comprising:
- an additive manufacturing tool (16) configured to receive a metallic material (20) and to supply a plurality of droplets to a part (12) at a work region (24) of the part (12), wherein each droplet of the plurality of droplets comprises the metallic material (20);
- a heating system (26) configured to heat a substrate (14) of the part (12), wherein the heating system (26) is configured to generate a molten zone (50) and a transition zone (52) disposed about the molten zone (50); and
- a controller (32) configured to regulate respective positions of the additive manufacturing tool (16) and the heating system (26) such that the work region (24) and the molten zone (50) are colocated and such that the transition zone (52) is disposed about the molten zone (50),
wherein heating system (26) comprises:
- a primary laser system (54) configured to generate a primary laser beam (58); and
- a secondary laser system (56) configured to generate a secondary laser beam (62),
wherein the primary laser beam (58) is configured to heat the molten zone (50), and the secondary laser beam (62) is configured to heat the transition zone (52),
**characterized in that**
the secondary laser system (56) is configured to shape the transition zone (52) as an annular or ring-shaped zone disposed about the molten zone (50) and to control a temperature of the transition zone (52), wherein the transition zone (52) has a thickness (64) of approximately 1/3 or 1/2 of a diameter (60) of the molten zone (50), and
wherein the controller (32) is configured to regulate operation of the secondary laser system (56), such that the transition zone (52) has a temperature within 5 to 20 degrees Centigrade less than the temperature of the molten zone (50).

2. The system (10) of claim 1,
wherein the controller (32) is configured to regulate operation of the primary laser system (54), such that the molten zone (50) has a temperature equal to or greater than a melting temperature of the substrate (14).

3. The system (10) of claim 1,
wherein the heating system (26) comprises at least one sensor (46) configured to detect a position of the additive manufacturing tool (16).

4. The system (10) of claim 1,
wherein the metallic material (20) comprises a solid metal wire.

5. The system (10) of claim 4,
wherein the molten zone (50) comprises a diameter at least two times greater than a diameter of the solid metal wire.

6. The system (10) of one of the preceding claims,
wherein the substrate (14) of the part (12) comprises refractory metals, titanium-based alloys, nickel-based alloys, cobalt-based alloys, or a combination thereof.

7. The system (10) of one of the preceding claims,
wherein the heating system (26) comprises at least one heating plate (100) configured to be positioned against an edge (102) of the substrate (14).

8. The system (10) of claim 7,
wherein the at least one heating plate (100) comprises a ceramic heating plate comprising an integrated heating element (104).

9. A method, comprising:
- heating a molten zone (50) of a substrate (14);
- heating a transition zone (52) of the substrate (14), wherein the transition zone (52) is disposed about the molten zone (50); and
- forming metallic droplets on the substrate (14) in the molten zone wherein the molten zone (50) of the substrate (14) is heated with a primary laser system (54) and the transition zone (52) of the substrate (14) is heated with a secondary laser system (56),
**characterized in that**
the transition zone (52) is shaped as an annular or ring-shaped zone disposed about the molten zone (50) in which the temperature is controlled,
wherein the transition zone (52) has a thickness (64) of approximately 1/3 or 1/2 of a diameter (60) of the molten zone (50), and
wherein operation of the secondary laser system (56) is regulated such that the transition zone (52) has a temperature within 5 to 20 degrees Centigrade less than the temperature of the molten zone (50).

10. The method of claim 9,
comprising adjusting a position of an additive manufacturing tool (16) forming the metallic droplets and simultaneously adjusting respective positions of the primary laser system (54) and secondary laser system (56) to adjust respective positions of the molten zone (50) and the transition zone (52).

11. The method of claim 9 or 10,
comprising heating an edge (102) of the substrate (14) with a heated plate (100) when the molten zone (50) is adjacent to the edge (102) of the substrate (14).

12. The method of claim 11,
comprising positioning the heated plate (100) against the edge of the substrate (14).

13. The method of one of claims 9 to 12,
comprising detecting a position of an additive manufacturing tool (16) forming the metallic droplets with at least one sensor (46) and adjusting respective positions of the molten zone (50) and the transition zone (52) based on the detected position of the additive manufacturing tool (16).

## Patentansprüche

1. Additives Fertigungssystem (10), aufweisend:
- ein additives Fertigungswerkzeug (16), das so konfiguriert ist, dass es ein metallisches Material (20) aufnimmt und eine Vielzahl von Tröpfchen einem Teil (12) an einem Arbeitsbereich (24) des Teils (12) zuführt, wobei jedes Tröpfchen der Vielzahl von Tröpfchen das metallische Material (20) aufweist;
- ein Heizsystem (26), das so konfiguriert ist, dass es ein Substrat (14) des Teils (12) erwärmt, wobei das Heizsystem (26) so konfiguriert ist, dass es eine Schmelzzone (50) und eine Übergangszone (52) erzeugt, die um die Schmelzzone (50) angeordnet ist; und
- eine Steuerung (32), die so konfiguriert ist, dass sie jeweilige Positionen des additiven Fertigungswerkzeugs (16) und des Heizsystems (26) so regelt, dass der Arbeitsbereich (24) und die Schmelzzone (50) gemeinsam angeordnet sind und dass die Übergangszone (52) um die Schmelzzone (50) herum angeordnet ist,
wobei das Heizsystem (26) Folgendes aufweist:
- ein primäres Lasersystem (54), das so konfiguriert ist, dass es einen primären Laserstrahl (58) erzeugt; und
- ein sekundäres Lasersystem (56), das so konfiguriert ist, dass es einen sekundären Laserstrahl (62) erzeugt,
wobei der primäre Laserstrahl (58) so konfiguriert ist, dass er die Schmelzzone (50) erwärmt, und der sekundäre Laserstrahl (62) so konfiguriert ist, dass er die Übergangszone (52) erwärmt,
**dadurch gekennzeichnet, dass**
das sekundäre Lasersystem (56) so konfiguriert ist, dass es die Übergangszone (52) als eine annulare oder ringförmige Zone formt, die um die Schmelzzone (50) angeordnet ist, und eine Temperatur der Übergangszone (52) steuert,
wobei die Übergangszone (52) eine Dicke (64) von ungefähr 1/3 oder 1/2 eines Durchmessers (60) der Schmelzzone (50) hat, und
wobei die Steuerung (32) so konfiguriert ist, dass sie den Betrieb des sekundären Lasersystems (56) so regelt, dass die Übergangszone (52) eine Temperatur innerhalb von 5 bis 20 Grad Celsius niedriger als die Temperatur der Schmelzzone (50) hat.

2. System (10) nach Anspruch 1,
wobei die Steuerung (32) so konfiguriert ist, dass sie den Betrieb des primären Lasersystems (54) so regelt, dass die Schmelzzone (50) eine Temperatur gleich oder größer als eine Schmelztemperatur des Substrats (14) hat.

3. System (10) nach Anspruch 1,
wobei das Heizsystem (26) zumindest einen Sensor (46) aufweist, der so konfiguriert ist, dass er eine Position des additiven Fertigungswerkzeugs (16) erfasst.

4. System (10) nach Anspruch 1,
wobei das metallische Material (20) einen massiven Metalldraht aufweist.

5. System (10) nach Anspruch 4,
wobei die Schmelzzone (50) einen Durchmesser aufweist, der zumindest zweimal größer ist als ein Durchmesser des massiven Metalldrahts.

6. System (10) nach einem der vorhergehenden Ansprüche,
wobei das Substrat (14) des Teils (12) Refraktärmetalle, Legierungen auf Titanbasis, Legierungen auf Nickelbasis, Legierungen auf Kobaltbasis oder eine Kombination davon aufweist.

7. System (10) nach einem der vorhergehenden Ansprüche,
wobei das Heizsystem (26) zumindest eine Heizplatte (100) aufweist, die konfiguriert ist, um an einer Kante (102) des Substrats (14) positioniert zu werden.

8. System (10) nach Anspruch 7,
wobei die zumindest eine Heizplatte (100) eine Keramikheizplatte aufweist, die ein integriertes Heizelement (104) aufweist.

9. Verfahren, aufweisend:
- Erwärmen einer Schmelzzone (50) eines Substrats (14);
- Erwärmen einer Übergangszone (52) des Substrats (14), wobei die Übergangszone (52) um die Schmelzzone (50) herum angeordnet ist; und
- Bilden von Metalltröpfchen auf dem Substrat (14) in der Schmelzzone
wobei die Schmelzzone (50) des Substrats (14) mit einem primären Lasersystem (54) erwärmt wird und die Übergangszone (52) des Substrats (14) mit einem sekundären Lasersystem (56) erwärmt wird,
**dadurch gekennzeichnet, dass**
die Übergangszone (52) als eine annulare oder ringförmige Zone geformt ist, die um die Schmelzzone (50) angeordnet ist, in der die Temperatur gesteuert wird,
wobei die Übergangszone (52) eine Dicke (64) von ungefähr 1/3 oder 1/2 eines Durchmessers (60) der Schmelzzone (50) hat, und
wobei der Betrieb des sekundären Lasersystems (56) so geregelt wird, dass die Übergangszone (52) eine Temperatur innerhalb von 5 bis 20 Grad Celsius niedriger als die Temperatur der Schmelzzone (50) hat.

10. Verfahren nach Anspruch 9,
aufweisend das Einstellen einer Position eines additiven Fertigungswerkzeugs (16), das die Metalltröpfchen bildet, und das gleichzeitige Einstellen jeweiliger Positionen des primären Lasersystems (54) und des sekundären Lasersystems (56), um jeweilige Positionen der Schmelzzone (50) und der Übergangszone (52) einzustellen.

11. Verfahren nach Anspruch 9 oder 10,
aufweisend das Erwärmen einer Randes (102) des Substrats (14) mit einer beheizten Platte (100), wenn die Schmelzzone (50) an dem Rand (102) des Substrats (14) angrenzt.

12. Verfahren nach Anspruch 11,
aufweisend das Positionieren der beheizten Platte (100) gegen den Rand des Substrats (14).

13. Verfahren nach einem der Ansprüche 9 bis 12,
aufweisend das Erfassen einer Position eines additiven Fertigungswerkzeugs (16), das die Metalltröpfchen bildet, mit zumindest einem Sensor (46), und Einstellen jeweiliger Positionen der Schmelzzone (50) und der Übergangszone (52) basierend auf der erfassten Position des additiven Fertigungswerkzeugs (16).

## Revendications

1. Système d'impression 3D (10), comprenant :
- un outil d'impression 3D (16) configuré pour recevoir un matériau métallique (20) et pour fournir une pluralité de gouttelettes à une pièce (12) sur une région de travail (24) de la pièce (12), dans lequel chaque gouttelette parmi la pluralité de gouttelettes comprend le matériau métallique (20) ;
- un système de chauffage (26) configuré pour chauffer un substrat (14) de la pièce (12), dans lequel le système de chauffage (26) est configuré pour générer une zone de fusion (50) et une zone de transition (52) disposée autour de la zone de fusion (50) ; et
- un dispositif de commande (32) configuré pour réguler des positions respectives de l'outil d'impression 3D (16) et du système de chauffage (26) de sorte que la zone de travail (24) et la zone de fusion (50) soient colocalisées et de sorte que la zone de transition (52) soit disposée autour de la zone de fusion (50),
dans lequel le système de chauffage (26) comprend :
- un système laser principal (54) configuré pour générer un faisceau laser principal (58) ; et
- un système laser secondaire (56) configuré pour générer un faisceau laser secondaire (62),
dans lequel le faisceau laser principal (58) est configuré pour chauffer la zone de fusion (50), et le faisceau laser secondaire (62) est configuré pour chauffer la zone de transition (52),
**caractérisé en ce que**
le système laser secondaire (56) est configuré pour former la zone de transition (52) comme une zone annulaire ou circulaire disposée autour de la zone de fusion (50) et pour contrôler une température de la zone de transition (52),
dans lequel la zone de transition (52) a une épaisseur (64) d'environ 1/3 ou 1/2 d'un diamètre (60) de la zone de fusion (50), et
dans lequel le dispositif de commande (32) est configuré pour réguler le fonctionnement du système laser secondaire (56), de sorte que la zone de transition (52) ait une température dans une plage de 5 à 20 degrés centigrades inférieure à la température de la zone de fusion (50).

2. Système (10) selon la revendication 1,
dans lequel le dispositif de commande (32) est configuré pour réguler le fonctionnement du système laser principal (54), de sorte que la zone de fusion (50) a une température égale ou supérieure à une température de fusion du substrat (14).

3. Système (10) selon la revendication 1,
dans lequel le système de chauffage (26) comprend au moins un capteur (46) configuré pour détecter une position de l'outil d'impression 3D (16).

4. Système (10) selon la revendication 1,
dans lequel le matériau métallique (20) comprend un fil métallique solide.

5. Système (10) selon la revendication 4,
dans lequel la zone de fusion (50) comprend un diamètre au moins deux fois supérieur à un diamètre du fil métallique solide.

6. Système (10) selon l'une quelconque des revendications précédentes,
dans lequel le substrat (14) de la pièce (12) comprend des métaux réfractaires, des alliages à base de titane, des alliages à base de nickel, des alliages à base de cobalt, ou une combinaison de ceux-ci.

7. Système (10) selon l'une quelconque des revendications précédentes,
dans lequel le système de chauffage (26) comprend au moins une plaque chauffante (100) configurée pour être positionnée contre un bord (102) du substrat (14).

8. Système (10) selon la revendication 7,
dans lequel l'au moins une plaque chauffante (100) comprend une plaque chauffante en céramique comprenant un élément chauffant intégré (104).

9. Procédé comprenant :
- le chauffage d'une zone de fusion (50) d'un substrat (14) ;
- le chauffage d'une zone de transition (52) du substrat (14), dans lequel la zone de transition (52) est disposée autour de la zone de fusion (50) ; et
- la formation de gouttelettes métalliques sur le substrat (14) dans la zone de fusion
dans lequel la zone de fusion (50) du substrat (14) est chauffée avec un système laser principal (54) et la zone de transition (52) du substrat (14) est chauffée avec un système laser secondaire (56),
**caractérisé en ce que**
la zone de transition (52) se présente est formée comme une zone annulaire ou circulaire disposée autour de la zone de fusion (50) dans laquelle la température est contrôlée,
dans lequel la zone de transition (52) a une épaisseur (64) d'environ 1/3 ou 1/2 d'un diamètre (60) de la zone de fusion (50), et
dans lequel le fonctionnement du système laser secondaire (56) est régulé de sorte que la zone de transition (52) a une température dans la plage de 5 à 20 degrés centigrades inférieure à la température de la zone de fusion (50).

10. Procédé selon la revendication 9,
comprenant l'ajustement d'une position d'un outil d'impression 3D (16) formant les gouttelettes métalliques et l'ajustement simultané des positions respectives du système laser principal (54) et du système laser secondaire (56) pour ajuster les positions respectives de la zone de fusion (50) et de la zone de transition (52).

11. Procédé selon la revendication 9 ou 10,
comprenant le chauffage d'un bord (102) du substrat (14) avec une plaque chauffée (100) lorsque la zone de fusion (50) est adjacente au bord (102) du substrat (14).

12. Procédé selon la revendication 11,
comprenant le positionnement de la plaque chauffée (100) contre le bord du substrat (14).

13. Procédé selon l'une quelconque des revendications 9 à 12, comprenant la détection d'une position d'un outil d'impression 3D (16) formant les gouttelettes métalliques avec au moins un capteur (46) et l'ajustement des positions respectives de la zone de fusion (50) et de la zone de transition (52) sur base de la position détectée de l'outil d'impression 3D (16).
